(19) Europäisches Patentamt
European Patent Office
Office européen des brevets

(11) **EP 4 270 702 A1**

(12) **EUROPEAN PATENT APPLICATION**

(43) Date of publication:
**01.11.2023 Bulletin 2023/44**

(21) Application number: **22170637.7**

(22) Date of filing: **28.04.2022**

(51) International Patent Classification (IPC):
*H02H 3/42* (2006.01)    *G01R 31/08* (2020.01)
*H02H 7/26* (2006.01)

(52) Cooperative Patent Classification (CPC):
**H02H 3/425; G01R 31/08; H02H 7/26**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Hitachi Energy Switzerland AG
5400 Baden (CH)**

(72) Inventor: **Gajic, Zoran
723 47 Västerås (SE)**

(74) Representative: **AWA Sweden AB
Box 45086
104 30 Stockholm (SE)**

(54) **A METHOD OF DETECTING A FAULT IN A TRANSMISSION LINE OF A POWER TRANSMISSION SYSTEM**

(57)    A method of detecting a fault in a protected line constituting at least a portion of a transmission line in a power transmission system, the transmission line having at least one phase. The method comprises:
- determining a positive sequence power, a negative sequence power and a zero sequence power for a positive sequence, a negative sequence and a zero sequence, respectively, of the power in the protected line, determining whether a criterion is fulfilled, wherein the criterion is based on at least one of a composite sequence power determined on basis of the positive sequence power, the negative sequence power and the zero sequence power; and at least one expression determined on basis of at least two of the positive sequence power, the negative sequence power and the zero sequence power, and
- if it is determined that the criterion is fulfilled, then determining that a fault has been detected on the protected line.

Fig. 1

EP 4 270 702 A1

**Description**

TECHNICAL FIELD

The present disclosure generally relates to power transmission systems, and more particularly it relates to a method and a system of detecting a fault in a protected line constituting at least a portion of a transmission line in a power transmission system.

BACKGROUND

In a power transmission system, such as a high voltage (HV) or a medium voltage (MV) power transmission system, there is a risk for major short-circuit faults, e.g. from a phase to ground or between phases. Such faults have to be detected and remedied as soon as possible. Therefore, the transmission lines are monitored. Prior art solutions typically utilize measurements of current or impedance. They have clear shortcomings. For example, to identify a position of a fault along the transmission line, there may be a need of sending measurement values between devices at different ends of the transmission line. The prior art methods have very high demands for the time synchronization of the devices in order to generate a correct result. Additionally, as regards impedance measurements they have shortcomings regarding e.g. high-impedance faults, semaphore effect due to remote end infeed, impedance measurement even for the healthy phases, etc.

SUMMARY

In view of the foregoing, a concern of the present disclosure is how to reduce the shortcomings of the prior art.

To better address this concern, in a first aspect thereof, the present disclosure provides a method for detecting a fault in a protected line constituting at least a portion of a transmission line in a power transmission system, the transmission line having at least one phase. The method comprises:
determining a positive sequence power, a negative sequence power and a zero sequence power for a positive sequence, negative sequence and zero sequence, respectively, of the power in the protected line, determining whether a criterion is fulfilled, wherein the criterion is based on at least one of a composite sequence power determined on basis of the positive sequence power, the negative sequence power and the zero sequence power; and at least one expression determined on basis of at least two of the positive sequence power, the negative sequence power and the zero sequence power; and if it is determined that the criterion is fulfilled, then determining that a fault has been detected on the protected line.

By using the composite sequence power as such, or the at least one expression, easier ways to detect different fault indicators are obtainable and some requirements may be relaxed.

According to a further aspect the criterion may be based on at least one of a composite sequence power determined on basis of the positive sequence power, the negative sequence power and the zero sequence power; an expression determined on basis of a relation between at least two of the positive sequence power, the negative sequence power and the zero sequence power; and an expression determined on basis of at least one of the positive sequence power, the negative sequence power and the zero sequence power and a threshold value.

Said criterion may be based on an expression of a composite sequence power according to:

$$S_{Cmp}=k_1*S_1-(k_2*S_2+k_0*S_0)$$

where $S_{Cmp}$ is the composite sequence power, $S_1$ is the positive sequence power, $S_2$ is the negative sequence power, $S_0$ is the zero sequence power, and $k_1$, $k_2$, $k_0$ are settable non-negative weighting factors.

Said determining a comparison value may comprise determining a delta value of the composite sequence power as a difference between a present composite sequence power value and a previous composite sequence power value. The determination of the delta value comprises determining an active power delta value as a difference between an active power part of the present composite sequence power value and an active power part of the previous composite sequence power value, and determining a reactive power delta value as a difference between a reactive power part of the present composite sequence power value and a reactive power part of the previous composite sequence power value.

The method may further comprise determining a first delta value of the composite sequence power at a first measurement point at an end of the protected line, comprising determining a first active power delta value and a first reactive power delta value at the first measurement point. The criterion constitutes that the first active power delta value and the first reactive power delta value are positive and above a predetermined threshold value. Said determining that a fault has been detected comprises determining that a fault has been detected in a forward direction from the first measurement point, wherein the forward direction is towards the protected line from the first measurement point. In other words, the forward direction points away from the measurement point along the protected line. The procedure of determining in which direction along the transmission line the fault has occurred is referred to as transient directionality. During steady state conditions the active power delta value and the reactive power delta value are typically zero, which facilitates the setting of an appropriate threshold value. Thereby the detection of a fault will be quick and reliable.

The method may further comprise determining a second delta value of the composite sequence power at a second measurement point at another end of the protected line at a distance from the first measurement point, said second delta value of the composite sequence power $\Delta S_{Cmp2}$ comprises a second active power delta value and a second reactive power delta value. The criterion constitutes that the first and the second active power delta values and the first and the second reactive power delta values are all positive and above the threshold value. Said determining that a fault has been detected on the protected line comprises determining that a fault has occurred between the first and second measurement points. Thereby a directional comparison is obtained, by which it can be determined whether the fault has occurred on the protected line between the measurement points, and by which there is no need to involve properties of the transmission line such as line impedances.

For a situation where the protected line comprises at least two ends, the method may comprise determining the composite sequence power value at each end of the protected line, determining a differential sequence power as a sum of the composite sequence powers at the ends. The criterion constitutes that the differential sequence power exceeds a threshold value. Thereby, a differential protection is obtained where, due to the use of the composite sequence power which in this respect can be regarded as time-invariant, the requirements of synchronization between the ends is relaxed in comparison with the prior art methods based on measuring currents/impedances of the transmission line.

For a situation where the protected line comprises at least two ends, the method may comprise determining the composite sequence power value at each end of the protected line, and determining a differential sequence power as a difference between a sum of the composite sequence powers at the ends of the protected line and a power loss along the transmission line, wherein the criterion constitutes that the differential sequence power value exceeds a threshold value.

By taking account of the power loss the determination is more adapted to long transmission lines.

Furthermore, the differential sequence power may be determined according to:

$$ S_{Diff} = \sum_{m=1}^{n} S_{Cmp_m} - S_{Loss} = (\sum_{m=1}^{n} P_{Cmp_m} - P_{Loss}) + j * (\sum_{m=1}^{n} Q_{Cmp_m} - Q_{Loss}) $$

where $S_{Cmp_m}$ is the composite sequence power at the m:th end, $P_{Cmp_m}$ is an active power part of the composite sequence power, $Q_{Cmp_m}$ is a reactive power part of the composite sequence power, $S_{Loss}$ is the power loss along the transmission line, $P_{Loss}$ is active power loss along the transmission line, $Q_{Loss}$ is reactive power loss along the transmission line, and $n$ is the number of ends of the protected line.

The method may comprise determining the sequence power values at a reach point positioned along the transmission line at a distance from a measurement point, wherein the measurement point is positioned at an end of the protected line, and determining delta power values at the reach point by means of the sequence power values at the reach point, wherein each delta sequence power value is a difference between a present sequence power value and a previous sequence power value. The criterion is based on the delta sequence values. Said determining that a fault has been detected comprises determining that a fault has occurred between the measurement point and the reach point. Thereby, a distance protection is obtained where actual measurements of the impedance of the transmission line are not needed.

The delta power values may include a delta power value of the positive sequence power at the reach point and a delta power value of a combination of the negative sequence power at the reach point and the zero sequence power at the reach point.

Said determining delta sequence power values may comprise determining an equation according to:

$$ \Delta S_1@RP < \Delta S_{20}@RP $$

where $\Delta S_1@RP$ is the delta sequence power value of the positive sequence power at the reach point, and $\Delta S_{20}@RP$ is the delta sequence power value of the combination of the negative sequence power at the reach point and the zero sequence power at the reach point.

The method may further comprise determining, at the measurement point, first voltage phasors and first current phasors for the different sequences, determining second current phasors at the reach point by means of the first current phasors, determining second voltage phasors at the reach point by means of the first voltage phasors, the first current phasors, line impedances of the transmission line and a reach factor related to said distance, determining the sequence power values at the reach point by means of the second voltage phasors and the second current phasors, and determining the delta sequence power values at the reach point by means of the sequence power values at the reach point.

Said determining that at fault has occurred between the measurement point and the reach point may comprise determining that the fault is an unsymmetrical fault.

The power transmission system may be a three-phase system, but the method is applicable to power transmission systems having other number of phases, both more and less than three, as well.

Said determining delta sequence power values at the reach point may include employing a reach factor related to the distance and a predetermined transmission line impedance. The method may further comprise recursively estimating a value of the reach factor for which an expression according to $\Delta Q_1@RP=\Delta Q_{20}@RP$ is valid, wherein $\Delta Q_1@RP$ is a reactive power part of the delta sequence power for the positive sequence, and $\Delta Q_{20}@RP$ is a reactive power part of the delta power value of the combination. Thereby, in addition, the position of the fault is determined as well, since said expression is only valid at the fault point.

According to another aspect there is provided a fault detection system for a power transmission system comprising a transmission line, which in turn comprises a protected line constituting at least a portion of the transmission line, wherein the transmission line has at least one phase. The fault detection system comprises an intelligent electronic device (111, 112, 113), which is connectable to the transmission line, and which is configured to detect a fault on the protected line, wherein the intelligent electronic device is configured to:

- determine a positive sequence power, a negative sequence power and a zero sequence power for a positive sequence, a negative sequence and a zero sequence, respectively, of the power in the protected line;
- determine whether a criterion is fulfilled, wherein the criterion is based on at least one of a composite sequence power determined on basis of the positive sequence power, the negative sequence power and the zero sequence power; and at least one expression determined on basis of at least two of the positive sequence power, the negative sequence power and the zero sequence power; and
- if it is determined that the criterion is fulfilled, then determine that a fault has been detected on the protected line.

This fault detection system provides for the corresponding advantages as the above method.

According to a further aspect the criterion may be based on at least one of a composite sequence power determined on basis of the positive sequence power, the negative sequence power and the zero sequence power; an expression determined on basis of a relation between at least two of the positive sequence power, the negative sequence power and the zero sequence power; and an expression determined on basis of at least one of the positive sequence power, the negative sequence power and the zero sequence power and a threshold value.

The criterion may be based on an expression of a composite sequence power according to:

$$S_{Cmp}=k_1{}^*S_1-(k_2{}^*S_2+k_0{}^*S_0)$$

where $S_{Cmp}$ is the composite sequence power, $S_1$ is the positive sequence power, $S_2$ is the negative sequence power, $S_0$ is the zero sequence power, and $k_1$, $k_2$, $k_0$ are non-negative and settable weighting factors.

The intelligent electronic device may be configured to determine a delta value of the composite sequence power as a difference between a present composite sequence power value and a previous composite sequence power value, comprising determining an active power delta value as a difference between an active power part of the present composite sequence power value and an active power part of the previous composite sequence power value, and determining a reactive power delta value as a difference between a reactive power part of the present composite sequence power value and a reactive power part of the previous composite sequence power value.

The intelligent electronic device is connectable to the transmission line at a measurement point positioned at an end of the protected line. The intelligent electronic device may be configured to determine the sequence power values at a reach point positioned along the transmission line at a distance from the measurement point, and to determine delta sequence power values at the reach point by means of the sequence power values at the reach point. Each delta sequence power value is a difference between a present sequence power value and a previous sequence power value. The criterion is based on the delta sequence values. The determination that a fault has been detected comprises determining that a fault has occurred between the measurement point and the reach point.

The delta power values may include a delta power value of the positive sequence power at the reach point and a delta power value of a combination of the negative sequence power at the reach point and the zero sequence power at the reach point.

According to another aspect there is provided a computer program product comprising instructions which, when downloaded into an intelligent electronic device, cause the intelligent electronic device to carry out the above-described method. The computer program product may be realized as a carrier containing code for the instructions, such as a portable memory device, a computer program stored on a computer readable medium, such as a server, a hard disc, downloadable computer program code, etc. as understood by the person skilled in the art. For the purposes of this application it is to be noted that the term power transmission system refers to any suitable power transmission system, such as alternating current (AC) and alternating/direct (AC/DC) current transmission systems. The term transmission line refers to any suitable AC transmission line, such as an HVAC transmission line, an MVAC transmission line, also referred to as a distribution line, long distance and short distance transmission lines, etc. The term protected line refers to a part of the transmission line, which is being monitored for faults. The term forward direction refers to a reference direction pointing from the measurement point towards the protected line.

BRIEF DESCRIPTION OF THE DRAWINGS

Exemplifying embodiments will now be described in more detail and with reference to the appended drawings in which:

> Fig. 1 shows a block diagram of an embodiment of the present fault detection system arranged in a transmission system;
> Fig. 2 shows a flowchart of an embodiment of the present fault detection method; and
> Fig. 3 is an illustration of power conditions in a transmission line subjected to a fault.

DETAILED DESCRIPTION

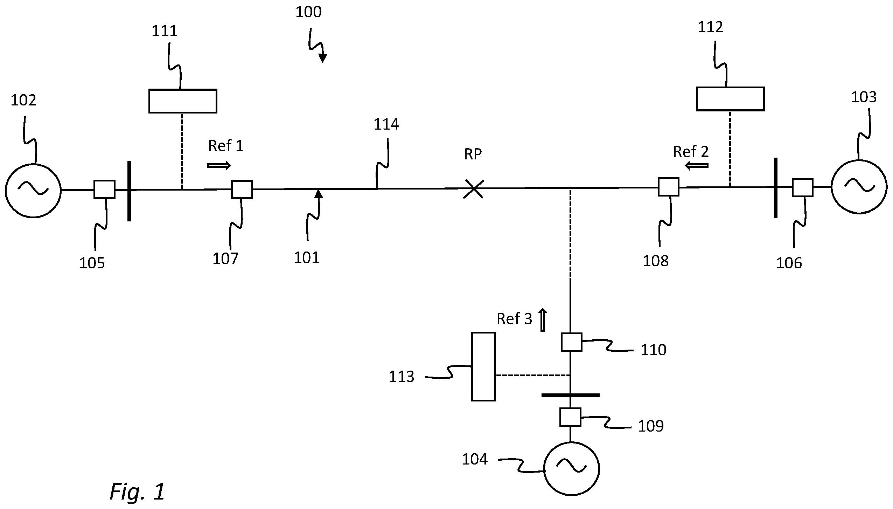

Fig. 1 shows a most general example of a power transmission system 100 comprising a transmission line 101 having one or more phases, for example three phases, and at least two ends. In the illustrated example there are three ends where one thereof is shown as an alternative to a two-end transmission line. An electrical apparatus 102, 103, 104 is connected to the transmission line 101 at each end thereof. The electrical apparatus 102-104 may be an electrical source or an electrical load. The transmission line 101 is provided with one or more switching devices 105, 106, 107, 108, 109, 110 allowing opening of the circuit to restrict the flow of current in the power transmission system 100. A fault detection system for the power transmission system 100 comprises one or more Intelligent Electrical Devices (IEDs) 111, 112, 113. Each IED 111-113 is connected to the transmission line 101, typically at an end thereof, either directly or via some other device, and is arranged to monitor the electrical activity in the transmission line 101, for instance by means of measuring currents and voltages in the transmission line 101. Therefore, for the purposes of this disclosure, the portion of the transmission line 101 where an IED 111-113 is connected is called a measurement point. Furthermore, the IED 111-113 is arranged to detect a fault in the transmission line 101 and is arranged to switch one or more of the switching devices 105-110. It should be noted that the transmission line 101, or a portion thereof, that is monitored by the IED 111-113 constitutes the protected line 114.

As understood by the person skilled in the art the overall structure of the power transmission system shown in Fig. 1 is a mere example among an almost infinite number of different variants. To give just a brief view of the variety, and in addition to what has been described above, the power transmission system may be a part of or connected to the grid, the power sources may be different kinds of power sources such as wind power plants, solar power plants, nuclear power plants, a transformer, etc., the loads may be different kinds of loads such as a production site, etc. The power transmission system may comprise a plurality of transmission lines, etc. The transmission line may be an HV AC line or an MV AC line, it may extend between power sources, between a power source and a load, etc., and, thus, as recognized above, it may constitute what is also referred to as a distribution line. The length of the transmission line may vary to a large extent, from a few kilometers, or even shorter, up to hundreds of kilometers.

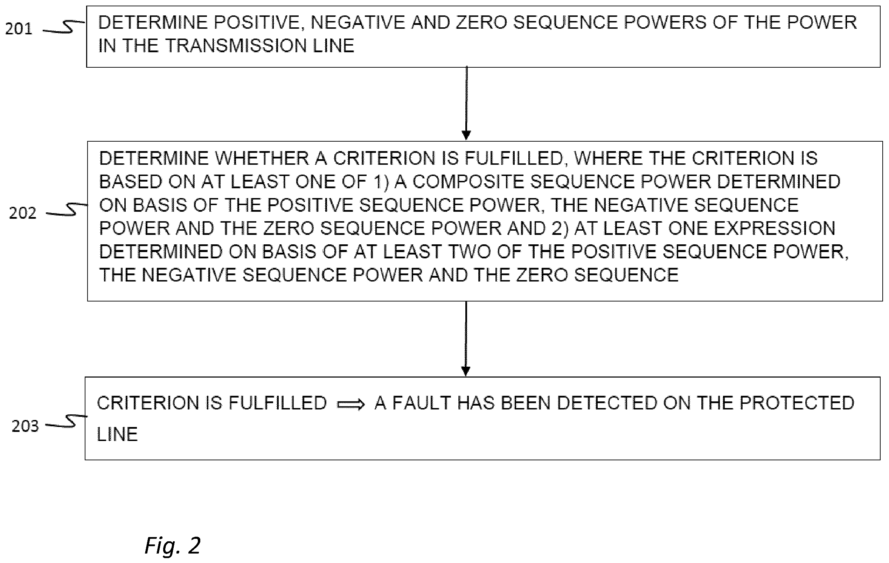

According to exemplifying embodiments of the present method of detecting a fault in a protected line 114, the method comprises operations as illustrated in the flow chart of Fig. 2. In a box 201, sequence powers of the transmission line 101 are determined. That is, a positive sequence power $S_1$ for a positive sequence, a negative sequence power $S_2$ for a negative sequence, and a zero sequence power $S_0$ for a zero sequence of the power in the transmission line 101 are determined. The method further comprises, in box 202, determining whether a criterion is fulfilled. The criterion is determined on basis of at least one of a composite sequence power $S_{Cmp}$ determined on basis of the positive sequence power $S_1$, the negative sequence power $S_2$ and the zero sequence power $S_0$; and at least one expression determined on basis of at least two of the positive sequence power $S_1$, the negative sequence power $S_2$ and the zero sequence power $S_0$. If the criterion is fulfilled, then it is determined that a fault has been detected on the protected line 114, box 203.

The criterion may be based on an expression determined on basis of at least one of the positive sequence power $S_1$, the negative sequence power $S_2$ and the zero sequence power $S_0$, and additionally a threshold value.

The criterion may be based on an expression of a composite sequence power according to

$$S_{Cmp}=k_1{}^*S_1-(k_2{}^*S_2+k_0{}^*S_0)$$

where $S_{Cmp}$ is the composite sequence power, $S_1$ is the positive sequence power, $S_2$ is the negative sequence power, $S_0$ is the zero sequence power, and $k_1$, $k_2$, $k_0$ are settable non-negative weighting factors.

Determining a criterion on basis of the composite sequence power $S_{Cmp}$ and/or an expression based on at least two of the sequence powers includes different possible alternatives, such as using one or more of the sequence powers in the determination, using the resulting composite sequence power in different ways, determining instant values, determining delta values, predicting future values, determining values relative to thresholds, etc. This will be apparent from and elaborated in the below examples.

For reasons of clarity, an example of how to determine the sequence powers will now be given for a three-phase transmission line. The IED 111-113 is arranged to measure phase current and phase voltage signals of the three phases. A reference direction Ref is determined as pointing away from the end where the IED 111-113 is connected towards another end of the transmission line 101. In order to clearly identify phase and sequence components the following nomenclature will be used throughout this application:

    1. Phase quantities will be indicated with index A, B and C (e.g. $I_A$, $I_B$ and Ic)
    2. Sequence quantiles will be indicated by index 1, 2 and 0 for positive negative and zero sequence component respectively (e.g. $I_1$, $I_2$ and $I_0$).
    3. All values given in the examples will be presented in per-unit or percent system.

The fundamental frequency phasors for three-phase voltage and current signals shall be derived. The signals are sampled and a full cycle Discrete Fourier Transform (DFT) filter, or some other appropriate type of filtering, may be applied. Then, the phasors of the sequence components for currents and voltages are calculated by using a well-known matrix equation, as shown below for the current signals. The voltage phasors are similarly calculated.

$$\begin{pmatrix} I_0 \\ I_1 \\ I_2 \end{pmatrix} = \frac{1}{3} * \begin{pmatrix} 1 & 1 & 1 \\ 1 & a & a^2 \\ 1 & a^2 & a \end{pmatrix} * \begin{pmatrix} I_A \\ I_B \\ I_C \end{pmatrix}$$

The character "a" denotes a complex operator; $a = e^{j*120°} = e^{j*120°}$, and i = $j = \sqrt{-1}$ . Thus, the positive, negative and zero sequence current phasors $I_1$, $I_2$, $I_0$ are all determined by different combinations of the phase currents $I_A$, $I_B$, $I_C$.

The sequence powers $S_1$, $S_2$, $S_0$, being complex values, are then calculated using a well-known formula as follows:

$$S_1 = U_1 * I_1^{<c>} = P_1 + j * Q_1$$

$$S_2 = U_2 * I_2^{<c>} = P_2 + j * Q_2$$

$$S_0 = U_0 * I_0^{<c>} = P_0 + j * Q_0$$

where "$< c >$" indicates that the current phasor value shall be complex-conjugated before the multiplication is performed, $P$ is the active power, and Q is the reactive power.

Having thereby determined the sequence powers, the composite sequence power is calculated according to an expression as follows:

$$S_{Cmp}=k_1{}^*S_1-(k_2{}^*S_2+k_0{}^*S_0)$$

where $S_{Cmp}$ is the composite sequence power, $S_1$ is the positive sequence power, $S_2$ is the negative sequence power, $S_0$ is the zero sequence power, and $k_1$, $k_2$, $k_0$ are non-negative and settable weighting factors.

This expression for the composite sequence power can be developed as follows:

$$S_{Cmp} = k_1 * S_1 - k_2 * S_2 - k_0 * S_0 = P_{Cmp} + j * Q_{Cmp}$$

As mentioned above, the weighting factors $k_1$, $k_2$, $k_0$ are non-negative and settable. For the following considerations, in order to simplify this description, the weighting factors are all chosen to be 1.0, i.e. $k_1 = k_2 = k_0 = 1.0$. However, the weighting factors can be given other values in order to boost influence of some sequence power component in the total value of the composite sequence power.

The negative and zero sequence powers $S_2$, $S_0$ are taken with a negative sign in the expression for the composite sequence power $S_{Cmp}$ because they actually flow in a direction opposite to that of the positive sequence power $S_1$. Thereby, they will add up to the positive sequence power and the sensitivity of the present method will be increased.

Furthermore, the expression of the composite sequence power $S_{Cmp}$ is useful for detecting different kinds of faults in the transmission line 101 as will be evident below.

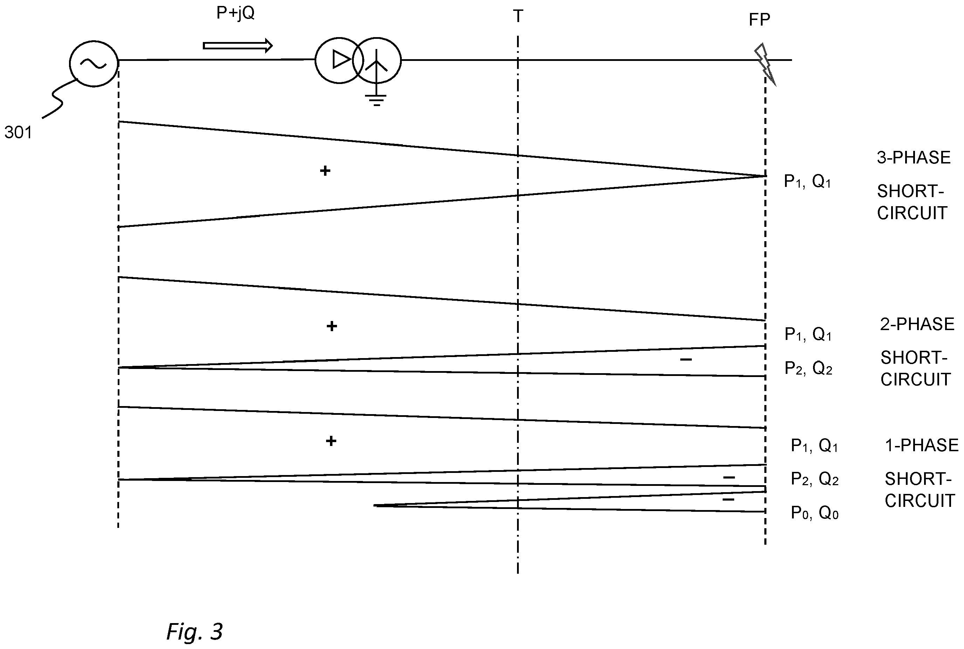

The method of detecting a fault in a protected line in a power transmission system according to the present disclosure, originates in novel findings based on previous knowledge about how power becomes distributed in a power transmission line in the presence of short-circuits, as shown in Fig. 3. The shown situation is for an ideal case, where there is no fault resistance at the fault point and the power transmission system is not loaded before the fault occurs. However, some basic principles which are illustrated in Fig. 3 are generally valid. A relationship between the sequence powers at the fault point (FP) can be expressed as:

$$S_1@FP = -(S_2@FP + S_0@FP)$$

In words this can be expressed and understood as that at the fault point FP the positive sequence power will be equal to the sum of the negative and zero sequence powers but with the opposite sign. In physical sense the negative sign means that the negative sequence power and the zero sequence power reflect back from the fault point and flow from the fault point towards the source 301, which is indicated to the left in Fig. 3. This is even true for a symmetrical three-phase fault but then the zero and negative sequence powers $S_0$, $S_2$ are equal to zero at the fault point FP and in the whole power transmission system.

It should also be noted that at any arbitrary point T between the source 201 and the fault point FP as shown in Fig. 3, and consequently at the point where the IED is connected as well, the following relationship would always be valid:

$$S_1@T > -(S_2@T + S_0@T)$$

It is to be noted that the weighting factors $k$ should all be equal to 1 here for a fully adequate result. In a real power transmission system 100 the following will be almost always valid:

1. The transmission line will be loaded before the fault and provide some power to the loads.
2. The fault will be fed from both sides of the protected line, or from all sides in case of multi-end transmission line.
3. Some fault resistance (variable or constant) will be present at the fault point.

Therefore, the above expression may be generalized in order to be valid during all operating conditions of the protected line. Based on the superposition theorem for an electrical circuit, the following general equation can be written for the sequence powers at the fault point:

$$\Delta S_1@FP = P_{RF} - (\Delta S_2@FP + \Delta S_0@FP)$$

where:

$\Delta S_1@FP$ is the change of the positive sequence power at the fault point FP due to the fault. By determining the delta value the impact of the load before the fault occurs is eliminated. The delta value of a sequence power is the difference between a current sequence power value and a previous sequence power value. For example, the delta value of the sequence power may be calculated by a time difference of two power transmission system cycles.
$\Delta S_2@FP$ is the change of the negative sequence power at the fault point FP due to the fault. Note that the negative sequence power is typically zero, i.e. non-existent, before the fault. However, by using its delta value it is possible to eliminate any non-symmetrical or non-linear load that is present before the fault.

$\Delta S_0@FP$ is the change of the zero sequence power at the fault point due to the fault. Note that the zero sequence power is typically zero, i.e. non-existent, before the fault. However, by using its delta value it is possible to eliminate any non-symmetrical or non-linear load before the fault.

$P_{RF}$ is the active power consumed by the fault point itself, i.e. power given to the fault resistance or electrical arc at the fault point. Note that this quantity cannot be directly measured. Neither can it be estimated in an easy way. However, this active power will be consumed for almost every real fault in a power transmission system. In words this can be expressed and understood as that at the fault point the change of the positive sequence power $S_1$ will be partly given to the fault resistance, i.e. consumed mostly as active power by the fault point/resistance itself, and partly reflected back as negative and zero sequence power $S_2$, $S_0$. This is even true for a symmetrical three phase fault but then the negative and zero sequence powers $S_2$, $S_0$ are equal to zero at the fault point and in the whole power system.

As explained above the flow of positive sequence power $S_1$, or its delta value $\Delta S_1$, will be in opposite direction to the flow of negative and zero sequence power $S_2$, $S_0$ or their delta values $\Delta S_2$, $\Delta S_0$ throughout the power transmission system. Consequently, defining a composite sequence power as a difference between them as mentioned above, that is:

$$S_{Cmp} = S_1 - S_2 - S_0 = P_{Cmp} + j * Q_{Cmp}$$

will result in that all sequence power values will add up to a combined actual sum. This can be regarded as using all three sequence powers $S_1$, $S_2$, $S_0$ in the same direction. Thereby, the total value will be larger, than if the sequence power values are added with their independent sign, and consequently comparisons made with such values will be more sensitive. Furthermore, such a composite sequence power value will have more or less constant value throughout the protected line if losses along the protected line are ignored.

As consequence, that will make the relative location of the IED 111-113 in respect to the fault point FP less important in comparison with a situation when three sequence components and their respective powers are used on a one-by-one basis for the protection purposes.

Furthermore, at any arbitrary point T between the source and the fault point, which arbitrary point T may be the location where IED is connected, the following relationship would always be valid:

$$\Delta S_1@T > -(\Delta S_2@T + \Delta S_0@T)$$

Use of this relationship between delta values of the sequence powers will be exemplified below.

According to embodiments of the method, the determination of a comparison value may comprise determining a delta value $\Delta S_{Cmp}$ of the composite sequence power $S_{Cmp}$ as a difference between a present composite sequence power value and a previous composite sequence power value according to the following expression:

$$\begin{aligned} \Delta S_{Cmp} = S_{Cmp}(present) - S_{Cmp}(previous) &= \Delta P_{Cmp} + j * \Delta Q_{Cmp} \\ &= \left(P_{Cmp}(present) - P_{Cmp}(previous)\right) + j * (Q_{Cmp}(present) \\ &\quad - Q_{Cmp}(previous)) \end{aligned}$$

Thus, the determination of the delta value of the composite sequence power $\Delta S_{Cmp}$ comprises determining an active power delta value $\Delta P_{Cmp}$ as a difference between the active power part $P_{Cmp}(present)$ of the present composite sequence power value $S_{Cmp}(present)$ and the active power part $P_{Cmp}(previous)$ of the previous composite sequence power value $S_{Cmp}(previous)$, and a reactive power delta value $\Delta Q_{Cmp}$ as a difference between the reactive power part $Q_{Cmp}(present)$ of the present composite sequence power value $S_{Cmp}(present)$ and a reactive power part $Q_{Cmp}(previous)$ of the previous composite sequence power value $S_{Cmp}(previous)$. The time difference between the present and previous values may, for instance, be two cycles of the power transmission system 100, where the cycle is related to the fundamental frequency.

The delta value of the composite sequence power $\Delta S_{Cmp}$ is useful for several different ways of determining faults on the protected line 114.

According to embodiments of the method, the method may comprise determining a first delta value of the composite sequence power $\Delta S_{Cmp1}$ at a first measurement point at an end of the protected line 114, e.g. where a first IED 111 is connected to the transmission line 101. The determination of $\Delta S_{Cmp1}$ may comprise determining a first active

power delta value $\Delta P_{Cmp1}$ and a first reactive power delta value $\Delta Q_{Cmp1}$ at the first measurement point. In this case, the criterion to be fulfilled in order to determine that a fault has been detected constitutes that the first active power delta value $\Delta P_{Cmp1}$ and the first reactive power delta value $\Delta Q_{Cmp1}$ are positive and above a predetermined threshold value. The predetermined threshold value may for example be 5%, or some other suitable value. Furthermore, it is determined that a fault has been detected in a forward direction from the first measurement point, wherein the forward direction is towards the protected line from the first measurement point, i.e. the reference direction Ref1 of the first IED 111.

According to embodiments of the present method it may further comprise determining a second delta value of the composite sequence power $\Delta S_{Cmp2}$ at a second measurement point at another end of the protected line 114 at a distance of the first measurement point. The second measurement point may be a portion of the transmission line 101 where a second IED 112 is connected. The second delta value of the composite sequence power $\Delta S_{Cmp2}$ comprises a second active power delta value $\Delta P_{Cmp2}$ and a second reactive power delta value $\Delta Q_{Cmp2}$. Here, the criterion constitutes that the first and the second active power delta values $\Delta P_{Cmp1}$, $\Delta P_{Cmp2}$ and the first and the second reactive power delta values $\Delta Q_{Cmp1}$, $\Delta Q_{Cmp2}$ are all positive and above the threshold value. The forward direction from the first measurement point, e.g. the reference direction Ref1 of the first IED 111, is towards the second measurement point. A forward direction from the second measurement point, e.g. the reference direction Ref2 of a second IED 112, is towards the protected line as well, which means towards the first measurement point. Thereby, the fulfilment of the criterion results in that it is determined that a fault has occurred between the first and second measurement points if the first and the second active power delta values $\Delta P_{Cmp1}$, $\Delta P_{Cmp2}$ and the first and the second reactive power delta values $\Delta Q_{Cmp1}$, $\Delta Q_{Cmp2}$ are all positive and above the threshold. The result of these operations may be referred to as a directional comparison, which is a method of determining that the fault has occurred on the protected line 114, extending between the first and second IEDs 111, 112. Having thereby concluded that the detected fault is somewhere on the protected line, the first IED 111 and/or the second IED 112 can control one or more of the switching devices 105-110 to break the current in the protected line. As understood, to ensure a correct fault detection there has to be communication between the IEDs 111, 112. However, the communication may be limited to sending a binary number, which indicates the direction, or indicates if the direction is forward or not. When the fault detection system comprises two or more IEDs 111-113, the fault detection may be carried out in one of the IEDs 111-113 or several or all of them. Each IED 111-113, which is to determine if a fault has occurred will receive the binary value(s) from the other IED(s) 111-113. By the above use of sequence powers all kinds of faults will be detected. However, it may not be possible to determine the faulted phase. This directional comparison method does not require any data about the protected line as such, e.g. positive and/or zero sequence line impedances are not needed as setting parameters.

According to embodiments of the present method, the method may comprise determining the composite sequence power value $S_{Cmp}$ at each end of the protected line 114 and determining a differential sequence power $S_{Diff}$ as a sum of at least the composite sequence powers $S_{Cmp}$ at the ends. The criterion to be fulfilled in order to determine that a fault has been detected constitutes that the differential sequence power $S_{Diff}$ exceeds a threshold value. This method is called differential fault detection, or differential protection. For instance, in a case with three ends on the protected line 114, like one of the options shown in Fig. 1, the composite sequence power value $S_{Cmp}$ is determined by all three IEDs 111-113, and a sum thereof is determined by each one of the IEDs 111-113 receiving the composite sequence power values from the other two IEDs. For an ideal line, i.e. without any P and Q losses, the sum of the composite sequence values $S_{Cmp}$ from the IEDs 111-113 shall be zero if there is no fault on the transmission line 101. By setting a threshold value slightly distanced from zero, such as for example at 5%, and comparing the sum, recalculated as a percentage of a nominal sum value, with the threshold, it is concluded that a fault has occurred on the transmission line 101 if the threshold is exceeded. The determination of the differential sequence power can be mathematically expressed as:

$$S_{Diff} = \sum_{m=1}^{n} S_{Cmp_m} = \sum_{m=1}^{n} P_{Cmp_m} + j * \sum_{m=1}^{n} Q_{Cmp_m}$$

where n is the number of ends of the transmission line 101, i.e. $n \geq 2$. Thus, the sum of the composite sequence power values $S_{Cmp_m}$ is used as a comparison value, and it is compared with a threshold. Thus, the criterion may be expressed as "the differential sequence power value exceeds the threshold".

As an alternative, the delta value of the differential sequence power may be used, that is:

$$\Delta S_{Diff} = \sum_{m=1}^{n} \Delta S_{Cmp_m}$$

In this differential fault detection method, as in the above directional comparison, the time-invariance of the complex power value is employed to relax the time synchronization requirement for the communication between the IEDs. In other words, since sequence powers are used, and the composite sequence power during normal conditions varies little and slowly in comparison with the currents, the timing requirements of the synchronization can be relaxed compared to the timing requirements of a prior art method based directly on the current measurements. As an example, the time synchronization requirement may be in the order of one to three milliseconds for power measurement, for a 50Hz power transmission system. This is to be compared with the prior art using current based differential fault detection, which requires a time synchronization in the order of one micro-second. Consequently, for a power based differential fault detection the time synchronization requirement is significantly relaxed. At the same time the required data bandwidth for the communication is also considerably reduced because only two real quantities, i.e. $P_{Cmp}$ and $Q_{Cmp}$ are transferred between the IEDs 111-113. Additionally, these two quantities are almost constant during steady-state conditions which can further be used to lower the required communication bandwidth.

However, it should be noted that in reality there are P and Q power losses along the transmission line 101, having a noticeable impact on at least longer transmission lines. Therefore, for the longer transmission lines 101 the expression for determining the differential sequence power $S_{Diff}$ may be modified in order to include power losses on the transmission line 101, according to:

$$S_{Diff} = \sum_{m=1}^{n} S_{Cmp_m} - S_{Loss} = (\sum_{m=1}^{n} P_{Cmp_m} - P_{Loss}) + j * (\sum_{m=1}^{n} Q_{Cmp_m} - Q_{Loss})$$

where:

$P_{Loss}$ is active power loss along the transmission line 101. It can be estimated as $R_1 * |I_1|^2$
$Q_{Loss}$ is reactive power loss along the transmission line 101. It can be estimated as $X_1 * |I_1|^2 - B_1 * |U_1|^2$
$R_1$ is positive sequence resistance of the transmission line 101
$X_1$ is positive sequence reactance of the transmission line 101
$B_1$ is positive sequence susceptance of the transmission line 101

For the alternative method where the delta differential sequence power $\Delta S_{Diff}$ is determined, the power losses may be neglected because in case of an internal fault, i.e. a fault on the protected line, power changes at all ends of the transmission line 101 will be positive indicating internal fault irrespective of any power losses as explained above.

A further example of fault detection in the transmission line 101 is called distance fault detection, or distance protection. The aim of the distance protection is to detect if the fault is on the protected line based on only local measurements. This may be done by defining one or more distance protection zones. For instance, two protection zones may be defined, where the first protection zone covers 80% of the protected line 114 and the second protection zone covers 120% of the protected line 114. The location at the remote end of the protection line 114 with respect to the location of the IED 111-113, i.e. at for example 80% or 120% of the protected line, which in turn can be substantially the total length of the transmission line 101, is denoted reach point RP. To perform the distance protection some transmission line properties will be taken into account. They include, but are not limited to, a line positive sequence impedance $Z_{1L}$, and a line zero sequence impedance $Z_{0L}$. If a parallel transmission line exists, which is not shown in the figures, a line mutual zero sequence impedance $Z_{ML}$ may be used as well. Based on those properties and the chosen protection zone, represented by a reach factor r, which will be 0.8 for the 80% case and 1.2 for the 120% case, and measured sequence current and sequence voltage phasors at the IED location, i.e. at the measurement point, it is possible to determine the sequence powers at the set reach point RP. In other words, the reach factor r is related to the distance from the measurement point, i.e. where the IED 111-113 is connected to the transmission line 101, to the reach point RP.

Thus, according to embodiments of the method, the method may comprise determining the sequence power values $S_1$, $S_2$, $S_0$ at the reach point RP positioned along the transmission line 101 at a distance from a measurement point, and thus from an IED 111-113, and determining delta sequence power values $\Delta S_1$, $\Delta S_2$, $\Delta S_0$ at the reach point RP by means of the sequence power values at the reach point. On basis of the delta sequence power values it may be determined that a fault has occurred between the measurement point and the reach point. The method still will have a basis in the above defined expression of the composite sequence power $S_{Cmp}$, but individual factors of the expression will be used instead of the composite sequence power as such, and they will be determined for the reach point, which will be denoted @RP.

For example, the delta sequence power values may include a delta sequence power value of the positive sequence power at the reach point $\Delta S_1 @RP$ and a delta sequence power value of a combination of the negative sequence power at the reach point and the zero sequence power at the reach point $\Delta S_{20} @RP$. A comparison value may then be

defined as:

$$\Delta S_1@RP < \Delta S_{20}@RP$$

Thus, when the criterion is fulfilled, i.e. when the delta value of the positive sequence power at the reach point $\Delta S_1@RP$ is less than the delta value of the combination of the negative sequence power at the reach point and the zero sequence power at the reach point $\Delta S_{20}@RP$, then a fault has been detected where the fault is located between the measurement point, i.e. the IED 111-113, and the reach point RP. For example, the combination may be the whole part of the expression that involves the negative and zero sequence powers and valid for the reach point, which is the negative sum of those powers, i.e. $S_{20}@RP = -(S_2@RP + S_0@RP)$.

The delta values of the sequence powers may be determined by determining, at the measurement point, e.g. at the first IED 111, first voltage phasors and first current phasors for the different sequences, here denoted $U_1@IED$, $U_2@IED$, $U_0@IED$, $I_1@IED$, $I_2@IED$, $I_0@IED$, determining second current phasors at the reach point, here denoted $I_1@RP$, $I_2@RP$, $I_0@RP$, by means of the first current phasors, determining second voltage phasors at the reach point, here denoted $U_1@RP$, $U_2@RP$, $U_0@RP$, by means of the first voltage phasors, the first current phasors, the line impedances $Z_{1L}$, $Z_{0L}$, of the transmission line 101, and the reach factor $r$, determining the sequence power values at the reach point by means of the second voltage phasors and the second current phasors, and determining the delta sequence power values at the reach point by means of the sequence power values at the reach point.

A more detailed example of the calculations performed to enable the detection of a distance fault is as follows. First the current and voltage phasors at the reach point RP are determined according to:

$$U_1@RP = U_1@IED - r * Z_{1L} * I_1@IED$$

$$U_2@RP = U_2@IED - r * Z_{1L} * I_2@IED$$

$$U_0@RP = U_0@IED - r * Z_{0L} * I_0@IED$$

$$I_1@RP = I_1@IED$$

$$I_2@RP = I_2@IED$$

$$I_0@RP = I_0@IED$$

This example is simplified in that, inter alia, the shunt capacitance of the transmission line 101/protected line 114 is not taken into account. However, that is not absolutely necessary to detect a fault within the set protection zone. Furthermore, it should be noted that other more complicated methods could be used as well to estimate sequence voltage and current components at the reach point, e.g. by using two port equivalent networks, line telegraphic equations, etc, taking also the shunt capacitance into account. Once the current and voltage sequence phasors are known at the set reach point RP the following sequence powers at reach point RP will be calculated:

$$S_1@RP = U_1@RP * I_1@RP^{<c>} = P_1@RP + j * Q_1@RP$$

$$S_2@RP = U_2@RP * I_2@RP^{<c>} = P_2@RP + j * Q_2@RP$$

$$S_0@RP = U_0@RP * I_0@RP^{<c>} = P_0@RP + j * Q_0@RP$$

$$S_{20}@RP = -(S_2@RP + S_0@RP) = P_{20}@RP + j * Q_{20}@RP$$

Note that, as described above, the combined sequence power at reach point $S_{20}@RP$ is taken as a negative sum of $S_2@RP$ and $S_0@RP$. Finally, the delta $S_1@RP$ and delta $S_{20}@RP$ values shall also be calculated. For example, this can be done by subtracting two power transmission system cycles old values from the presently calculated one, i.e. the term "previous" in the below expressions corresponds with "old value from two cycles ago".

$$\Delta S_1@RP = S_1@RP(present) - S_1@RP(previous) = \Delta P_1@RP + j * \Delta Q_1@RP$$

$$\Delta S_{20}@RP = S_{20}@RP(present) - S_{20}@RP(previous) =$$
$$= \Delta P_{20}@RP + j * \Delta Q_{20}@RP$$

Note also that when a fault point is within the set zone reach of the distance protection the above calculations will go beyond the actual fault point FP. As a result, the delta value of the positive sequence power $\Delta S_1$ becomes smaller than a the delta value of the combination of the negative and zero sequence powers $\Delta S_{20}$. Note that such a relationship between these two delta powers is physically impossible in any point of a real power transmission system but it is caused in calculations by the fact that the actual fault point is located between the measurement point and the set reach point RP for which the above the calculations are done.

A distance fault detection based on delta values of the sequence powers can be made by:

$$\Delta S_1@RP < \Delta S_{20}@RP + P_{RF}$$

Because this is a complex expression it can be separated in two real expressions as given below:

$$\Delta P_1@RP < \Delta P_{20}@RP + P_{RF}$$

$$\Delta Q_1@RP < \Delta Q_{20}@RP$$

Thus, $\Delta P_1@RP$, $\Delta P_{20}@RP + P_{RF}$, $\Delta Q_1@RP$, and $\Delta Q_{20}@RP$ are used as comparison values, and they are compared to each other in pairs. The criterion to be fulfilled in order to determine that a fault has been detected then is fulfilment of both those expressions. The first expression has an unknown term of active power consumed by the fault resistance $P_{RF}$. Thus, it is more difficult for it to be fulfilled for practical faults when fault resistance is present. This is a known problem for the distance fault detection when a larger fault resistance value can influence on the fault determination. The second expression for the reactive power is easier to use and offers a distinct advantage over traditional impedance-based distance protection. As shown in this expression there is no influence of the fault resistance on the reactive power part of this equation.

It may be noted that the above two expressions are only valid for all types of unsymmetrical faults. In case of a symmetrical three phase fault there is not any negative and zero sequence power in the system. In case of such a three-phase fault these two expressions may be revised according to:

$$\Delta P_1@RP < 0 + P_{FP} \sim 0$$

$$\Delta Q_1@RP < 0$$

By ignoring the fault resistance for a three-phase fault in the first of the two expression above the security of the determination is increased, since trip conditions, i.e. conditions for switching the switching device 105-110, are already fulfilled for some small positive values of $\Delta P_1@RP$ but the conclusion that a fault has occurred is slightly delayed until $\Delta P_1@RP$ becomes negative. In order to confirm that the fault is in the forward direction the transient directionality described above can be employed. Consequently, the following is true for three-phase faults:

$$\Delta P_1@RP < 0 \ AND \ \Delta P_1@IED > 0$$

$$\Delta Q_1@RP < 0 \; AND \; \Delta Q_1@IED > 0$$

Because sequence powers are used this distance protection operates for all types of fault in a three-phase fashion (i.e. it is not phase segregated). However, its main advantage would be speed of operation. Once again the second expression will typically be fulfilled first for most practical faults due to existence of a fault resistance (i.e. active power dissipation) at the fault point.

As a further example embodiment the method may be used to locate the fault by recursively finding the value for the reach factor $r$ of the set line impedance for which the relation $\Delta Q_1@RP=\Delta Q_{20}@RP$ is valid, because such relationship is only valid at the fault point. More particularly, determining delta sequence power values at the reach point may include employing the reach factor $r$ related to the distance and the predetermined transmission line impedance, e.g. $Z_{1L}$ and $Z_{0L}$. From the above determinations of voltage phasors containing the reach factor r it may be realized that it will be possible to recursively estimate a value of the reach factor $r$ for which an expression according to $\Delta Q_1@RP=\Delta Q_{20}@RP$ is valid. $\Delta Q_1@RP$ is a reactive power part of the delta sequence power for the positive sequence, and $\Delta Q_{20}@RP$ is a reactive power part of the delta power value of the combination.

While the present disclosure has been illustrated and described in detail in the drawings and foregoing description, such illustration and description are to be considered illustrative or exemplary and not restrictive.

Although features and elements are described above in particular combinations, each feature or element can be used alone without the other features and elements or in various combinations with or without other features and elements.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain features are recited in mutually different dependent claims does not indicate that a combination of these features cannot be used to advantage. Any reference signs in the claims should not be construed as limiting the scope.

## Claims

1. A method of detecting a fault in a protected line constituting at least a portion of a transmission line in a power transmission system, the transmission line having at least one phase, the method comprising:

    - determining a positive sequence power, a negative sequence power and a zero sequence power for a positive sequence, a negative sequence and a zero sequence, respectively, of the power in the protected line;
    - determining whether a criterion is fulfilled, wherein the criterion is based on at least one of a composite sequence power determined on basis of the positive sequence power, the negative sequence power and the zero sequence power; and at least one expression determined on basis of at least two of the positive sequence power, the negative sequence power and the zero sequence power; and
    - if it is determined that the criterion is fulfilled, then determining that a fault has been detected on the protected line.

2. The method according to claim 1, wherein the criterion is based on at least one of a composite sequence power determined on basis of the positive sequence power, the negative sequence power and the zero sequence power; an expression determined on basis of a relation between at least two of the positive sequence power, the negative sequence power and the zero sequence power; and an expression determined on basis of at least one of the positive sequence power, the negative sequence power and the zero sequence power and a threshold value and/or the criterion is based on an expression of a composite sequence power according to:

$$S_{Cmp}=k_1*S_1-(k_2*S_2+k_0*S_0)$$

where $S_{Cmp}$ is the composite sequence power, $S_1$ is the positive sequence power, $S_2$ is the negative sequence power, $S_0$ is the zero sequence power, and $k_1, k_2, k_0$ are settable non-negative weighting factors.

3. The method according to claim 1 or 2, comprising determining a delta value of the composite sequence power ($\Delta S_{Cmp}$) as a difference between a present composite sequence power value ($S_{Cmp}(present)$) and a previous composite sequence power value ($S_{Cmp}(previous)$), comprising determining an active power delta value ($\Delta P_{Cmp}$) as a difference between an active power part ($P_{Cmp}(present)$) of the present composite sequence power value and an active power part ($P_{Cmp}$(previous)) of the previous composite sequence power value, and determining a reactive power delta value ($\Delta Q_{Cmp}$) as a difference between a reactive power part ($Q_{Cmp}$(present)) of the present composite sequence power value and a reactive power part ($Q_{Cmp}$(previous)) of the previous composite sequence power value.

4. The method according to claim 3, comprising determining a first delta value of the composite sequence power ($\Delta S_{Cmp1}$) at a first measurement point at an end of the protected line (114), comprising determining a first active power delta value ($\Delta P_{Cmp1}$) and a first reactive power delta value ($\Delta Q_{Cmp1}$) at the first measurement point, wherein the criterion constitutes that the first active power delta value and the first reactive power delta value are positive and above a predetermined threshold value, and wherein said determining that a fault has been detected comprises determining that a fault has been detected in a forward direction from the first measurement point, wherein the forward direction is towards the protected line from the first measurement point.

5. The method according to claim 4, further comprising determining a second delta value of the composite sequence power ($\Delta S_{Cmp2}$) at a second measurement point at another end of the protected line at a distance from the first measurement point, said second delta value comprising a second active power delta value ($\Delta P_{Cmp2}$) and a second reactive power delta value ($\Delta Q_{Cmp2}$) at the second measurement point, wherein the criterion constitutes that the first and the second active power delta values and the first and the second reactive power delta values are all positive and above the threshold value, said determining that a fault has been detected on the protected line comprising determining that a fault has occurred between the first and second measurement points.

6. The method according to any one of the preceding claims, wherein the protected line (114) comprises at least two ends, comprising determining the composite sequence power value ($S_{Cmp}$) at each end of the protected line and determining a differential sequence power ($S_{Diff}$) as a sum of the composite sequence powers at the ends, wherein the criterion constitutes that the differential sequence power exceeds a threshold value.

7. The method according to any one of claims 1 to 5, wherein the protected line (114) comprises at least two ends, comprising determining the composite sequence power value ($S_{Cmp}$) at each end of the protected line, and determining a differential sequence power ($S_{Diff}$) as a difference between a sum of the composite sequence powers at the ends and a power loss ($S_{Loss}$) along the transmission line (101), wherein the criterion constitutes that the differential sequence power exceeds a threshold value.

8. The method according to claim 7, difference power is determined according to:

$$ S_{Diff} = \sum_{m=1}^{n} S_{Cmp_m} - S_{Loss} = \left( \sum_{m=1}^{n} P_{Cmp_m} - P_{Loss} \right) + j * \left( \sum_{m=1}^{n} Q_{Cmp_m} - Q_{Loss} \right) $$

where $S_{Cmp_m}$ is the composite sequence power at the m:th end, $S_{Cmp_m}$ is an active power part of the composite sequence power, $Q_{Cmp_m}$ is a reactive power part of the composite sequence power, $S_{Loss}$ is the power loss along the transmission line, $P_{Loss}$ is active power loss along the transmission line, $Q_{Loss}$ is reactive power loss along the transmission line, and $n$ is the number of ends of the protected line.

9. The method according to any one of the preceding claims, comprising determining the sequence power values at a reach point positioned along the transmission line at a distance from a measurement point, wherein the measurement point is positioned at an end of the protected line, and determining delta sequence power values at the reach point by means of the sequence power values at the reach point, wherein each delta sequence power value is a difference between a present sequence power value and a previous sequence power value, and wherein the criterion is based on the delta sequence values, said determining that a fault has been detected comprising determining that a fault has occurred between the measurement point and the reach point.

10. The method according to claim 9, wherein the delta power values include a delta power value of the positive sequence power at the reach point and a delta power value of a combination of the negative sequence power at the reach point and the zero sequence power at the reach point.

11. The method according to claim 10, said determining delta sequence power values comprising determining an equation according to:

$$\Delta S_1@RP < \Delta S_{20}@RP$$

where $\Delta S_1@RP$ is the delta sequence power value of the positive sequence power at the reach point, and $\Delta S_{20}@RP$ is the delta sequence power value of the combination of the negative sequence power at the reach point and the zero sequence power at the reach point.

12. The method according to claim 10, said determining delta sequence power values at the reach point includes employing a reach factor related to the distance and a predetermined transmission line impedance, the method further comprising recursively estimating a value of the reach factor for which an expression according to $\Delta Q_1@RP = \Delta Q_{20}@RP$ is valid, wherein $\Delta Q_1@RP$ is a reactive power part of the delta sequence power for the positive sequence, and $\Delta Q_{20}@RP$ is a reactive power part of the delta power value of the combination.

13. The method according to any one of claims 9 to 12, comprising determining, at the measurement point, first voltage phasors and first current phasors for the different sequences, determining second current phasors at the reach point by means of the first current phasors, determining second voltage phasors at the reach point by means of the first voltage phasors, the first current phasors, line impedances of the transmission line and a reach factor related to said distance, determining the sequence power values at the reach point by means of the second voltage phasors and the second current phasors, and determining the delta sequence power values at the reach point by means of the sequence power values at the reach point.

14. A fault detection system for a power transmission system (100) comprising a transmission line (101), which in turn comprises a protected line constituting at least a portion of the transmission line, wherein the transmission line has at least one phase, the fault detection system comprising an intelligent electronic device (111, 112, 113), which is connectable to the transmission line, and which is configured to detect a fault on the protected line, wherein the intelligent electronic device is configured to:

   - determine a positive sequence power, a negative sequence power and a zero sequence power for a positive sequence, a negative sequence and a zero sequence, respectively, of the power in the protected line;
   - determine whether a criterion is fulfilled, wherein the criterion is based on at least one of a composite sequence power determined on basis of the positive sequence power, the negative sequence power and the zero sequence power; and at least one expression determined on basis of at least two of the positive sequence power, the negative sequence power and the zero sequence power; and
   - if it is determined that the criterion is fulfilled, then determine that a fault has been detected on the protected line.

15. The fault detection system according to claim 14, wherein the criterion is based on at least one of a composite sequence power determined on basis of the positive sequence power, the negative sequence power and the zero sequence power; an expression determined on basis of a relation between at least two of the positive sequence power, the negative sequence power and the zero sequence power; and an expression determined on basis of at least one of the positive sequence power, the negative sequence power and the zero sequence power and a threshold value and/or the criterion is based on an expression of a composite sequence power according to:

$$S_{Cmp} = k_1 * S_1 - (k_2 * S_2 + k_0 * S_0)$$

where $S_{Cmp}$ is the composite sequence power, $S_1$ is the positive sequence power, $S_2$ is the negative sequence power, $S_0$ is the zero sequence power, and $k_1$, $k_2$, $k_0$ are non-negative and settable weighting factors.

16. The fault detection system according to claim 14 or 15, wherein the intelligent electronic device is configured to determine a delta value of the composite sequence power ($\Delta S_{Cmp}$) as a difference between a present composite sequence power value ($S_{Cmp}(present)$) and a previous composite sequence power value ($S_{Cmp}(previous)$), comprising determining an active power delta value ($\Delta P_{Cmp}$) as a difference between an active power part ($P_{Cmp}(present)$) of the present composite sequence power value and an active power part ($P_{Cmp}(previous)$) of the previous composite sequence power value, and determining a reactive power delta value ($\Delta Q_{Cmp}$) as a difference between a reactive power part ($Q_{Cmp}(present)$) of the present composite sequence power value and a reactive power part ($Q_{Cmp}(previous)$) of the previous composite sequence power value.

17. The fault detection system according to any one of claims 14 to 16, wherein the intelligent electronic device (111,

15

112, 113) is connectable to the transmission line at a measurement point positioned at an end of the protected line, wherein the intelligent electronic device is configured to determine the sequence power values at a reach point positioned along the transmission line at a distance from the measurement point, and determine delta sequence power values at the reach point by means of the sequence power values at the reach point, wherein each delta sequence power value is a difference between a present sequence power value and a previous sequence power value, and wherein the criterion is based on the delta sequence values, wherein the determination that a fault has been detected comprises determining that a fault has occurred between the measurement point and the reach point.

18. The fault detection system according to claim 17, wherein the delta power values include a delta power value of the positive sequence power at the reach point and a delta power value of a combination of the negative sequence power at the reach point and the zero sequence power at the reach point.

19. A computer program product comprising instructions which, when downloaded into an intelligent electronic device, connectable to a transmission line of a power transmission system, cause the intelligent electronic device to carry out the method of claim 1.

*Fig. 1*

201 — DETERMINE POSITIVE, NEGATIVE AND ZERO SEQUENCE POWERS OF THE POWER IN THE TRANSMISSION LINE

202 — DETERMINE WHETHER A CRITERION IS FULFILLED, WHERE THE CRITERION IS BASED ON AT LEAST ONE OF 1) A COMPOSITE SEQUENCE POWER DETERMINED ON BASIS OF THE POSITIVE SEQUENCE POWER, THE NEGATIVE SEQUENCE POWER AND THE ZERO SEQUENCE POWER AND 2) AT LEAST ONE EXPRESSION DETERMINED ON BASIS OF AT LEAST TWO OF THE POSITIVE SEQUENCE POWER, THE NEGATIVE SEQUENCE POWER AND THE ZERO SEQUENCE

203 — CRITERION IS FULFILLED $\implies$ A FAULT HAS BEEN DETECTED ON THE PROTECTED LINE

*Fig. 2*

*Fig. 3*

P+jQ

T

FP

301

3-PHASE SHORT-CIRCUIT

$P_1, Q_1$

2-PHASE SHORT-CIRCUIT

$P_1, Q_1$

$P_2, Q_2$

1-PHASE SHORT-CIRCUIT

$P_1, Q_1$

$P_2, Q_2$

$P_0, Q_0$

+

+

+

−

−

−

EP 4 270 702 A1

Europäisches
Patentamt
European
Patent Office
Office européen
des brevets

# EUROPEAN SEARCH REPORT

**Application Number**

**EP 22 17 0637**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2 231 725 A (LENEHAN BERNARD E ET AL) 11 February 1941 (1941-02-11) | 1,2,14, 15,19 | INV. H02H3/42 |
| A | * the whole document * | 3-13, 16-18 | G01R31/08 H02H7/26 |
| | ----- | | |
| X | MORO ALINE F N C ET AL: "Performance evaluation of power differential protection applied to half-wavelength transmission lines", ELECTRIC POWER SYSTEMS RESEARCH, ELSEVIER, AMSTERDAM, NL, vol. 209, 10 April 2022 (2022-04-10), XP087056326, ISSN: 0378-7796, DOI: 10.1016/J.EPSR.2022.107998 [retrieved on 2022-04-10] | 1-5,9, 14-17,19 | |
| A | * the whole document * | 6-8, 10-13,18 | |
| | ----- | | |
| X | YAKIMETS I V ET AL: "FAULT LOCATION IN POWER LINES BY MEASURING POWER FLOW", ELECTRICAL TECHNOLOGY RUSSIA, ZNACK, MOSCOW, RU, no. 2, 1 January 1999 (1999-01-01), pages 51-59, XP008032064, ISSN: 1028-7957 * the whole document * | 1,14,19 | |
| | ----- | | |

**TECHNICAL FIELDS SEARCHED (IPC)**

H02H
G01R

The present search report has been drawn up for all claims

| Place of search | Date of completion of the search | Examiner |
|---|---|---|
| Munich | 4 October 2022 | Trifonov, Antoniy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 17 0637

This annex lists the patent family members relating to the patent documents cited in the above-mentioned European search report.
The members are as contained in the European Patent Office EDP file on
The European Patent Office is in no way liable for these particulars which are merely given for the purpose of information.

04-10-2022

| Patent document cited in search report | | Publication date | Patent family member(s) | Publication date |
|---|---|---|---|---|
| US 2231725 | A | 11-02-1941 | NONE | |

For more details about this annex : see Official Journal of the European Patent Office, No. 12/82

EPO FORM P0459